(19) Europäisches Patentamt
European Patent Office
Office européen des brevets

(11) EP 3 150 741 A1

(12) EUROPEAN PATENT APPLICATION

(43) Date of publication:
05.04.2017 Bulletin 2017/14

(51) Int Cl.:
C23C 14/30 (2006.01)     C23C 14/08 (2006.01)
C23C 14/02 (2006.01)     F01D 5/28 (2006.01)

(21) Application number: 16189124.7

(22) Date of filing: 16.09.2016

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(30) Priority: 01.10.2015 GB 201517333

(71) Applicant: Rolls-Royce plc
London SW1E 6AT (GB)

(72) Inventors:
• Novovic, Donka
  Derby, Derbyshire DE24 8BJ (GB)
• Long, Kevin
  Derby, Derbyshire DE24 8BJ (GB)

(74) Representative: Rolls-Royce plc
Intellectual Property Dept SinA-48
PO Box 31
Derby DE24 8BJ (GB)

(54) A METHOD OF APPLYING A THERMAL BARRIER COATING TO A METALLIC ARTICLE AND A THERMAL BARRIER COATED METALLIC ARTICLE

(57)    A method of applying a thermal barrier coating to a metallic article (26) comprising ball nose milling the surface of the metallic article (26) to produce a pattern in the surface of the metallic article (26) and to produce a compressive residual stress in the subsurface layers of the metallic article (26). The pattern comprises a plurality of pockets (35) and a plurality of projections (37) on the surface of the metallic article (26). A thin adherent layer of oxide (40) is created on the metallic article (26).

A ceramic coating (42) is applied to the oxide layer (40) on the surface of the metallic article (26) such that the ceramic coating (42) deposits on the surface of the metallic article (26) in the pockets (35) and on and around the projections (37). The ceramic coating (42) is applied as a plurality of columnar ceramic grains (41) extending substantially perpendicularly away from the metallic article (26) and the columnar ceramic grains (41) extending from the oxide layer (40) on the metallic article (26).

FIG. 4

**Description**

The present disclosure relates to a method of applying a thermal barrier coating to a metallic article and to a thermal barrier coated metallic article and in particular relates to a method of applying a thermal barrier coating to a superalloy article and to a thermal barrier coated superalloy article.

High-pressure superalloy turbine blades, or turbine vanes, of gas turbine engines utilise a combination of internal cooling, external cooling and a ceramic thermal barrier coating (TBC) in order to lower the temperature of the substrate temperature of the superalloy turbine blades, or turbine vanes, to allow them to operate effectively within the high-pressure turbine of the gas turbine engine with minimal degradation. Ceramic thermal barrier coatings are deposited by plasma spraying or by electron beam physical vapour deposition (EBPVD).

In order to maintain adhesion of an electron beam physical vapour deposited (EBPVD) ceramic thermal barrier coating (TBC) for the life of the turbine blade, or turbine vane, a bond coating which forms a dense adherent and slow-growing oxide, e.g. alumina, bonding layer is required as an intermediate layer between the superalloy substrate of the turbine blade, or turbine vane, and the ceramic thermal barrier coating.

The bond coatings are generally either overlay coatings, e.g. MCrAlY bond coatings where M is one or more of nickel, cobalt and iron, Cr is chromium, Al is aluminium and Y is one or more of yttrium, ytterbium, lanthanum and other rare earth metals, or aluminide bond coatings. The aluminide bond coatings may for example comprise a simple aluminide bond coating, a chromium aluminide bond coating, a platinum aluminide bond coating or a chromium platinum aluminide bond coating. MCrAlY coating are generally deposited by thermal spraying or electron beam physical vapour deposition and aluminide coatings are generally deposited by chemical vapour deposition, e.g. pack aluminising, out of pack aluminising, slurry aluminising, etc.

A further bond coating comprises a platinum enriched surface layer on the superalloy substrate comprising platinum enriched gamma phase and platinum enriched gamma prime phase. Another bond coating comprises an overlay, e.g. MCrAlY, coating, a platinum enriched outer overlay layer and a platinum aluminide layer on the platinum enriched overlay layer. The platinum is generally deposited by electroplating and is diffusion heat treated.

Conventionally, the surface of the bond coating is prepared before the ceramic thermal barrier coating is applied by electron beam physical vapour deposition (EBPVD) to improve the adhesion of the ceramic thermal barrier coating to the bond coating and hence increase the working life of the ceramic thermal barrier coating. The surface of the bond coating is made smooth, by manual polishing, manual linishing, automated polishing or automated linishing followed by grit blasting, so that a uniform adherent oxide, e.g. alumina, bonding layer is formed.

The currently used manual, or automated, processes for polishing or linishing the surface of the metallic article, or the surface of the bond coating do not produce a uniform surface texture. The entire surface has to be polished to the same standard, typically based on the surface roughness value Ra, and not the entire surface texture.

The present disclosure seeks to provide a novel thermal barrier coated superalloy article which has an improved working life.

The present invention seeks to provide a novel method of applying a thermal barrier coating to a superalloy article to produce a thermal barrier coated article which has an improved working life.

According to a first aspect of the present disclosure there is provided a method of applying a thermal barrier coating to a metallic article comprising the steps of:-

(a) ball nose milling or bull nose milling the surface of the metallic article to produce a pattern in the surface of the metallic article and to produce a compressive residual stress in the surface and subsurface layers of the metallic article, the pattern comprising a plurality of pockets and a plurality of projections on the surface of the metallic article and/or a plurality of grooves and a plurality of ridges on the surface of the metallic article,

(b) creating a thin adherent layer of oxide on the metallic article, and

(c) applying a ceramic coating to the oxide layer on the surface of the metallic article such that the ceramic coating deposits on the surface of the metallic article in the pockets and on and around the projections and/or in the grooves and on the ridges, applying the ceramic coating as a plurality of columnar ceramic grains extending substantially perpendicularly away from the metallic article, the columnar ceramic grains extending from the oxide layer on the metallic article.

There may be a compressive residual stress of up to about 800MPa at the surface of the metallic article.

There may be a compressive residual stress of at least 500MPa at depths less than $10\mu m$ from the surface of the metallic article.

Step (a) may comprise providing part spherical shaped pockets in at least one region of the surface of the metallic article and providing grooves in at least one region of the surface of the metallic article.

Step (a) may comprise providing part spherical shaped pockets in at least one region of the surface of the metallic article and providing elongated pockets in at least one region of the surface of the metallic article.

Step (a) may comprise providing elongated pockets in at least one region of the surface of the metallic article with the pockets elongated in a first direction and providing elongated pockets in at least one region of the surface of the metallic article with the pockets elongated in a second direction different to the first direction.

Step (a) may comprise milling using a straight milling tool or a tapered milling tool.

Step (a) may use either conventional milling, e.g. up cutting, or climb milling, e.g. down cutting.

The dimensions of the pockets, projections and ridges may be controlled by changing one or more of the ball nose milling tool diameter, the number of flutes, the cutting edge geometry of the ball nose milling tool, the cutting angle, the cutting federate step over, the cutting speed and the depth of cut.

Step (a) may use milling with a cutter lead angle of 0° or any suitable cutter lead angle between and including -60° and +60°. Step (a) may use milling with a cutter tilt angle of 0° or any suitable cutter tilt angle between and including -60° and +60°.

Step (b) may comprise providing a bond coating on the metallic article and creating the thin adherent layer of oxide on the bond coating, and step (c) comprises applying the ceramic coating to the oxide layer on the surface of the bond coating.

Step (b) may comprise depositing the bond coating by applying the bond coating by electroplating and then heat treating the bond coating.

Step (b) may comprise applying a layer of platinum-group metal to the metallic article, applying the platinum-group metal by an electroplating process, heat treating the platinum-group-metal coated metallic article to diffuse the platinum-group metal into the metallic article to create a platinum-group metal enriched outer layer on the metallic article, and creating the thin adherent layer of oxide on the platinum-group metal enriched outer layer of the metallic article.

The metallic article may comprise a superalloy substrate, the superalloy substrate comprises a gamma phase and gamma prime phase, the platinum-group metal enriched outer layer comprises a platinum-group metal enriched gamma phase and a platinum-group metal enriched gamma prime phase.

Step (b) may comprise aluminising the platinum-group metal enriched outer layer on the metallic article to form a platinum-group metal aluminide layer on the metallic article and creating the thin adherent layer of oxide on the platinum-group metal aluminide layer of the metallic article.

The heat treatment may be carried out at a temperature in the range of 1100°C to 1200°C dependent upon the solution heat treatment temperature appropriate for the superalloy article.

The platinum-group metal may comprise platinum. The thickness of the layer of platinum as applied before heat treatment may be greater than $3\mu m$ and less than $12.5\mu m$.

The heat treatment may be carried out for one hour.

The thin adherent layer of oxide may be created by heating the platinum-group metal enriched outer layer in an oxygen containing atmosphere.

Alternatively step (b) may comprise enriching the metallic article with aluminium to form an aluminium enriched outer layer on the metallic article and creating the thin adherent layer of oxide on the aluminium enriched outer layer of the metallic article. Step (b) may comprise forming an aluminide layer on the metallic article and creating the thin adherent layer of oxide on the aluminide layer of the metallic article.

The ceramic coating may be applied by electron beam physical vapour deposition or plasma spray physical vapour deposition.

The thin adherent layer of oxide may be created during the process of electron beam physical vapour deposition.

The ceramic coating may comprise stabilised zirconia. The ceramic coating may comprise yttria stabilised zirconia, yttria and erbia stabilised zirconia, yttria and gadolinia stabilised zirconia or yttria, erbia and gadolinia stabilised zirconia or the ceramic coating may comprise at least one layer of two, three or all of these ceramics. The ceramic coating may for example comprise at least one layer of yttria stabilised zirconia and at least one layer of yttria and erbia stabilised zirconia, at least one layer of yttria stabilised zirconia and at least one layer of yttria and gadolinia stabilised zirconia, at least one layer of yttria stabilised zirconia and at least one layer of yttria, erbia and gadolinia stabilised zirconia, at least one layer of yttria and erbia stabilised zirconia and at least one layer of yttria and gadolinia stabilised zirconia, at least one layer of yttria and erbia stabilised zirconia and at least one layer of yttria, erbia and gadolinia stabilised zirconia or at least one layer of yttria and gadolinia stabilised zirconia and at least one layer of yttria, erbia and gadolinia stabilised zirconia. The ceramic coating may comprise at least one layer of yttria stabilised zirconia, at least one layer of yttria and erbia stabilised zirconia and at least one layer of yttria and gadolinia stabilised zirconia. The ceramic coating may comprise at least one layer of yttria stabilised zirconia, at least one layer of yttria and erbia stabilised zirconia and at least one layer of yttria, erbia and gadolinia stabilised zirconia. The ceramic coating may comprise at least one layer of yttria stabilised zirconia, at least one layer of yttria and gadolinia stabilised zirconia and at least one layer of yttria, erbia and gadolinia stabilised zirconia. The ceramic coating may comprise at least one layer of yttria and gadolinia stabilised zirconia, at least one layer of yttria and erbia stabilised zirconia and at least one layer of yttria, erbia and gadolinia stabilised zirconia. The ceramic coating may comprise at least one layer of yttria stabilised zirconia, at least one layer of yttria and erbia stabilised zirconia, at least one layer of yttria and gadolinia stabilised zirconia and at least one layer yttria, erbia and gadolinia stabilised zirconia.

The metallic article may be a nickel based superalloy or a cobalt based superalloy. The nickel based superalloy or the cobalt based superalloy may consist of less than 1 ppm weight of sulphur.

The metallic article may be a turbine blade, a turbine vane, a turbine shroud, an abradable seal, a combustion chamber tile or a combustion chamber wall.

The present disclosure also provides a thermal barrier coated metallic article, the metallic article having a milled surface, the milled surface having a pattern, the metallic article having a compressive residual stress in the surface and subsurface layers of the metallic article, the pattern comprising a plurality of pockets and a plurality of projections on the surface of the metallic article and/or a plurality of grooves and a plurality of ridges on the surface of the metallic article, a thin adherent layer of oxide on the metallic article, and

a ceramic coating on the oxide layer on the surface of the metallic article, the ceramic coating being deposited on the surface of the metallic article in the pockets and on and around the projections and/or in the grooves and on the ridges, the ceramic coating comprising a plurality of columnar ceramic grains extending substantially perpendicularly away from the metallic article, the columnar ceramic grains extending from the oxide layer on the metallic article.

There may be part spherical shaped pockets in at least one region of the surface of the metallic article and grooves in at least one region of the surface of the metallic article.

There may be part spherical shaped pockets in at least one region of the surface of the metallic article and elongated pockets in at least one region of the surface of the metallic article.

There may be elongated pockets in at least one region of the surface of the metallic article with the pockets elongated in a first direction and elongated pockets in at least one region of the surface of the metallic article with the pockets elongated in a second direction different to the first direction.

There may be a bond coating on the metallic article, the thin adherent layer of oxide is on the bond coating and the ceramic coating is on the oxide layer on the surface of the bond coating.

The bond coating may comprise a platinum-group metal enriched outer layer on the metallic article and the thin adherent layer of oxide is on the platinum-group metal enriched outer layer of the metallic article.

The metallic article may comprise a superalloy substrate, the superalloy substrate comprises a gamma phase and gamma prime phase, the platinum-group metal enriched outer layer comprises a platinum-group metal enriched gamma phase and a platinum-group metal enriched gamma prime phase.

Alternatively the bond coating may comprise a platinum-group metal aluminide layer on the metallic article and the thin adherent layer of oxide is on the platinum-group metal aluminide layer of the metallic article.

The platinum-group metal may comprise platinum.

Alternatively the bond coating may comprise an aluminium enriched outer layer on the metallic article and the thin adherent layer of oxide is on the aluminium enriched outer layer of the metallic article.

The bond coating may comprise an aluminide layer on the metallic article and the thin adherent layer of oxide is on the aluminide layer of the metallic article.

The ceramic coating may comprise stabilised zirconia. The ceramic coating may comprise yttria stabilised zirconia, yttria and erbia stabilised zirconia, yttria and gadolinia stabilised zirconia or yttria, erbia and gadolinia stabilised zirconia or the ceramic coating may comprise at least one layer of two, three or all of these ceramic coatings.

The metallic article may be a nickel based superalloy or a cobalt based superalloy. The nickel based superalloy or the cobalt based superalloy may consist of less than 1 ppm weight of sulphur.

The metallic article may be a turbine blade, a turbine vane, a turbine shroud, an abradable seal, a combustion chamber tile or a combustion chamber wall.

The skilled person will appreciate that except where mutually exclusive, a feature described in relation to any one of the above aspects of the invention may be applied mutatis mutandis to any other aspect of the invention.

Embodiments of the invention will now be described by way of example only, with reference to the Figures, in which:

Figure 1 is partially cut away view of a turbofan gas turbine engine having a thermal barrier coated metallic article according to the present disclosure.

Figure 2 is an enlarged perspective view of a thermal barrier coated metallic article according to the present disclosure.

Figure 3 is an enlarged diagrammatic cross-sectional through a thermal barrier coated metallic article according to the present disclosure.

Figure 4 is a further enlarged diagrammatic cross-sectional through the thermal barrier coated metallic article shown in Figure 3.

Figure 4A is a cross-sectional view in the direction of arrows Y-Y in figure 4.

Figure 4B is a cross-sectional view in the direction of arrows W-W in figure 4.

Figure 5 is a cross-sectional micro-photograph of a thermal barrier coated metallic according to the present disclosure.

Figure 6 is a two dimensional roughness, topography, plot for a surface machined using high speed ball nose milling.

Figure 7 is a three dimensional roughness, topography, plot for a surface machined using high speed ball nose milling.

Figure 8 is a two dimensional roughness, topography, plot for a surface machined using surface grinding.

Figure 9 is a three dimensional roughness, topography, plot for a surface machined using surface grinding.

Figure 10 is a showing the residual stress versus depth for different machining processes.

Figure 11 is a bar chart showing the relative spallation life for a thermal barrier coating according to the present disclosure, optimised, and a prior art thermal barrier coating, non-optimal.

Figure 12 is a flow chart showing a method of manufacturing a thermal barrier coated metallic article according to the present disclosure.

Figure 13 is a schematic diagram showing ball nose milling to produce a machined surface for a thermal barrier coated metallic article according to the present disclosure.

Figure 14 is an enlarged perspective view of a further thermal barrier coated metallic article according to the present disclosure.

Figure 15 is an enlarged diagrammatic cross-sectional view through the further thermal barrier coated article shown in Figure 14.

Figure 16 is an alternative enlarged diagrammatic cross-sectional view through the further thermal barrier coated article shown in Figure 14.

Figure 17 is another enlarged diagrammatic cross-sectional view through the further thermal barrier coated article shown in Figure 14.

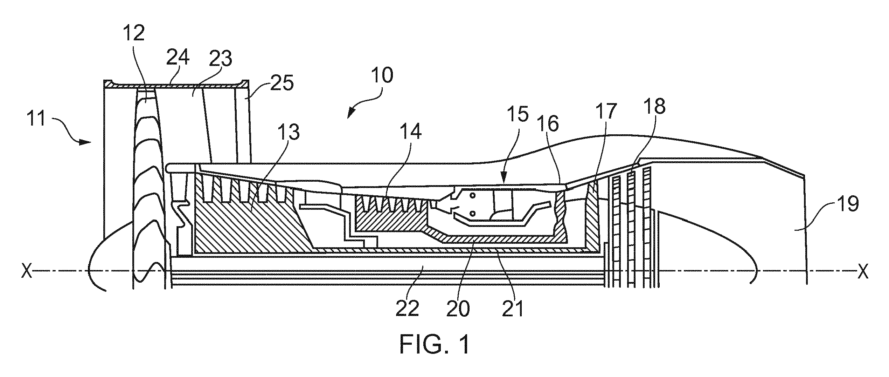

A turbofan gas turbine engine 10, as shown in Figure 1, comprises in flow series an intake 11, a fan 12, an intermediate pressure compressor 13, a high pressure compressor 14, a combustion chamber 15, a high pressure turbine 16, an intermediate pressure turbine 17, a low pressure turbine 18 and an exhaust 19. The high pressure turbine 16 is arranged to drive the high pressure compressor 14 via a first shaft 20. The intermediate pressure turbine 17 is arranged to drive the intermediate pressure compressor 13 via a second shaft 21 and the low pressure turbine 18 is arranged to drive the fan 12 via a third shaft 22. In operation air flows into the intake 11 and is compressed by the fan 12. A first portion of the air flows through, and is compressed by, the intermediate pressure compressor 13 and the high pressure compressor 14 and is supplied to the combustion chamber 15. Fuel is injected into the combustion chamber 15 and is burnt in the air to produce hot exhaust gases which flow through, and drive, the high pressure turbine 16, the intermediate pressure turbine 17 and the low pressure turbine 18. The hot exhaust gases leaving the low pressure turbine 18 flow through the exhaust 19 to provide propulsive thrust. A second portion of the air bypasses the main engine and flows through a bypass duct 23 defined by a fan casing 24. The second portion of air leaving the bypass duct 23 flows through a bypass, or fan, nozzle 25 to provide propulsive thrust.

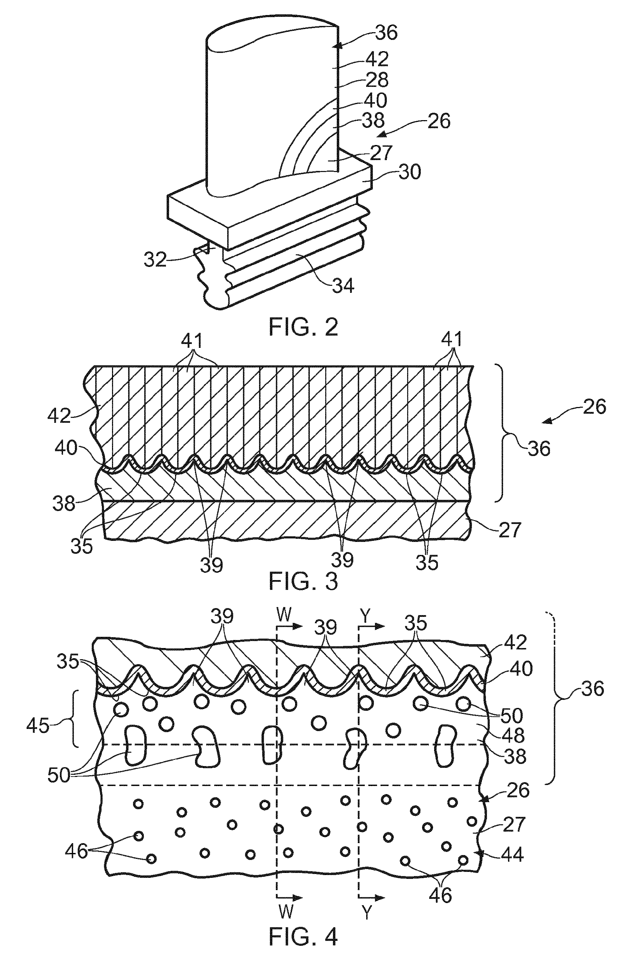

A thermal barrier coated metallic, e.g. a superalloy, article is shown in Figure 2, the metallic, superalloy, article may be a turbine rotor blade, a turbine stator vane, an abradable seal for a turbine or a combustion chamber tile. In this example the superalloy article is a turbine rotor blade 26 which comprises an aerofoil portion 28, a platform portion 30, a shank portion 32 and a root portion 34. The turbine rotor blade 26 is positioned, in use, on a turbine rotor (not shown) in the high pressure turbine 16, the intermediate pressure turbine 17 or the low pressure turbine 18. The turbine blade 26 is provided with a multilayer thermal barrier coating 36 at least on the surfaces which define the gas path through the respective turbine, e.g. the surface of the aerofoil portion 28 and the radially outer surface of the platform portion 30.

Referring to Figure 3, illustrating the superalloy article 26 provided with a multi-layer thermal barrier coating indicated generally by numeral 36. It is shown in the "as manufactured" condition. The thermal barrier coating 36 comprises a platinum enriched outer layer 38 on the surface of the substrate of the superalloy article 26, a thin oxide layer 40 on the platinum enriched layer 38 and a ceramic coating 42 on the thin oxide layer 40. The superalloy article 26, which forms the superalloy substrate 27 for the coating 36, is made of a nickel based superalloy or a cobalt based superalloy or an iron based superalloy. The nickel based superalloy, the cobalt based superalloy or the iron based superalloy preferably has less than 1 ppm by weight of sulphur.

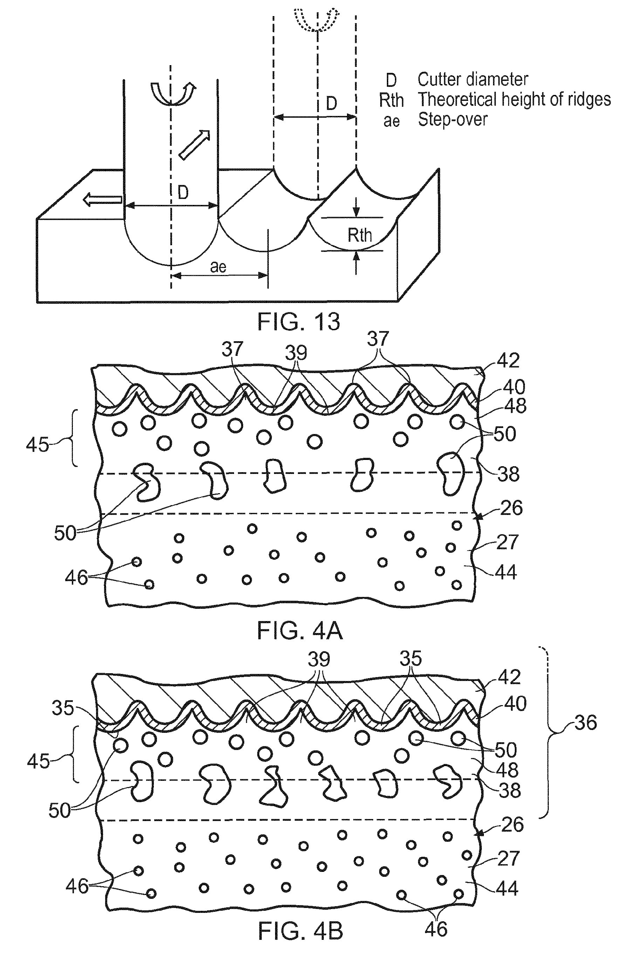

More particularly, the thermal barrier coated superalloy article 26 comprises a platinum enriched outer layer 38 on the superalloy article 26, the surface of the platinum enriched outer layer 38 on the superalloy article 26 has a microstructure comprising a patterned surface including a plurality of pockets, or dimples, 35 in the surface of the superalloy article 26, a plurality of projections 37 extending away from the surface of the platinum enriched outer layer 38 and a plurality of ridges 39 extending between adjacent projections 37 and positioned between adjacent pockets 35 as seen more clearly in Figures 4, 4A and 4B. The pockets 35 are generally part spherical shaped pockets and have a generally part spherical surface. Each ridge 39 generally has a lower height than the adjacent projections 37. A thin adherent layer of oxide 40 on the platinum enriched outer layer 38 of the superalloy article 26, a ceramic coating 42 on the oxide layer 40 on the patterned surface on and around the projections 37, over the ridges 39 and on and in the pockets 35, and the ceramic coating 42 has a columnar grain structure comprising a plurality of columnar ceramic grains 41.

The pockets 35 in the surface of the superalloy article 26 are generally arranged such that the centres of the pockets 35 are arranged in a regular pattern, for example the centres of the pockets 35 may be arranged at the corners of a square, the corners of a triangle etc. Alternatively, the pockets 35 may be elongated in one direction such that each pocket 35 comprises two part spherical ends and a part circular cross-section groove between the part spherical ends of the pocket 35 with ridges 39 separating adjacent grooves. The grooves and ridges 39 are arranged parallel to each other. The elongated pockets 35 may advantageously be machined such that they extend in the general flow direction of the gases over the surface of the superalloy article 26. In the case of a turbine blade, or a turbine vane, the elongated pockets 35 would extend generally axially, in the chordal direction of the aerofoil portion 28 of the turbine blade, or turbine vane and extend generally axially of the platform portions 30 of the turbine blade, or turbine vane. In the case of a combustion chamber wall or combustion chamber tile or combustion chamber segment the grooves and ridges would extend generally axially. In a turbine blade 26, or a turbine vane, the elongated pockets 35 at each region of the surface of the aerofoil portion 28 and the platform portion 30 are arranged to extend in the local flow direction of the gases over the surface of the turbine blade 26 or turbine vane, except for regions of the surface where there are secondary flows.

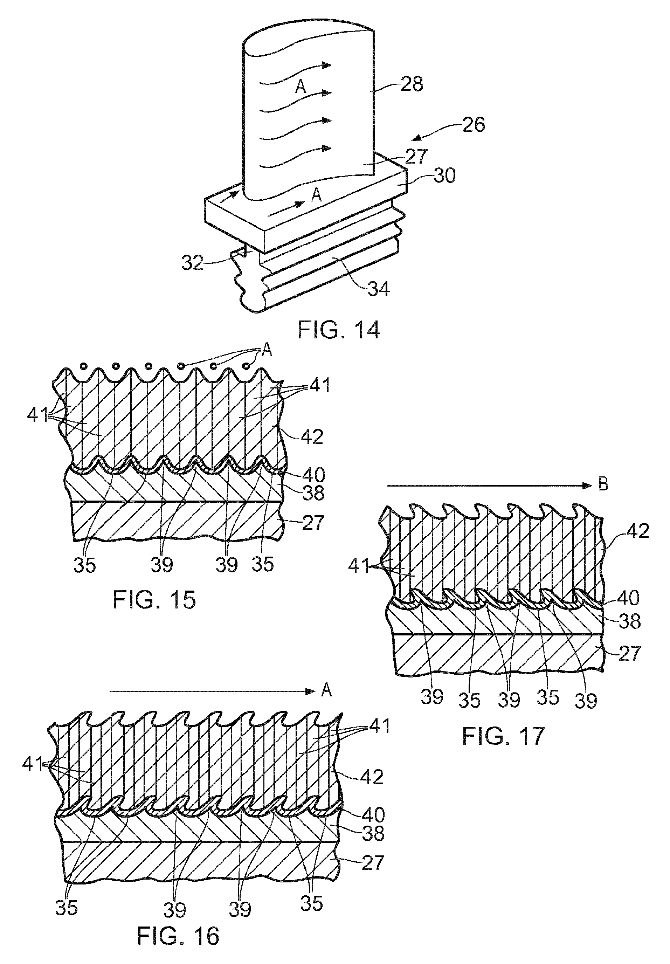

Alternatively, with reference to figures 3 and 4 the patterned surface of the superalloy article 26 may include circular cross-section grooves 35 separated by ridges 39. The grooves and ridges 39 are arranged parallel to each other. The circular cross-section grooves 35 and ridges 39 may advantageously be machined such that they extend in the general flow direction A of the gases over the surface of the superalloy article 26, as shown in figures 14 and 15. In the case of a turbine blade, or a turbine vane, the grooves 35 and ridges 39 would extend generally axially, in the chordal direction of the aerofoil portion 28 of the turbine blade, or turbine vane and extend generally axially of the platform portions 30 of the turbine blade, or turbine vane. In the case of a combustion chamber wall or combustion chamber tile or combustion chamber segment the grooves and ridges would extend generally axially. This would improve the cooling effectiveness and hence increase the working life of the superalloy article 26. In a turbine blade 26, or a turbine vane, the grooves 35 and ridges 39 at each region of the surface of the aerofoil portion 28 and the platform portion 30 are arranged to extend in the local flow direction of the gases over the surface of the turbine blade 26 or turbine vane, except for regions of the surface where there are secondary flows.

A further alternative is to provide the part spherical shaped pockets in at least one region of the surface of the superalloy article and to provide grooves in at least one region of the surface of the article. An additional alternative is to provide the part spherical shaped pockets in at least one region of the surface of the superalloy article and to provide the elongated pockets in at least one region of the surface of the article. It may be possible to provide elongated pockets in at least one region of the surface of the article with the pockets elongated in a first direction and to provide elongated pockets in at least one region of the surface of the article with the pockets elongated in a second direction different to the first direction. A further possibility is to provide a mixture of part spherical shaped pockets and elongated pockets in one or more regions of the surface of the article.

To produce the coating 36 the following procedure is followed. Initially, those parts or the whole of the surface of the superalloy article 26 requiring a thermal barrier coating are machined to produce the patterned surface. In particular, the surface of the superalloy article 26 is machined by ball nose milling using a ball nose milling tool to produce a plurality of pockets 35, projections 37 and ridges 39 on/in the surface of the superalloy article 26. The movement of the ball nose milling tool is controlled to produce a uniform machined surface texture, e.g. a uniform distribution of pockets 35, projections 37 and ridges 39, in the surface of the superalloy article 26. Then, after cleaning of the surface of the superalloy article 26 degreasing, a layer of platinum 45 having a substantially constant thickness of about 10μm was applied to the superalloy substrate 27. Alternatively, the cleaning may include grit blasting with fin alumina grit. The thickness or the platinum layer may again vary upwards from about 3μm, to about 12.5μm depending upon a number of factors, such as substrate, diffusion temperatures and service conditions. In some instances the platinum layer may be up to 25μm thick. The platinum layer 45 was applied by electroplating, but any other suitable means could be used which will achieve a sufficient substantially uniform thickness without detriment to the material's properties. A diffusion heat treatment step was then effected so as to cause the platinum layer 45 to combine with the superalloy substrate 27. This provided the platinum enriched outer layer 38 on the superalloy substrate 27. Diffusion was achieved by heating the superalloy article 26 to a temperature of 1150°C in a vacuum chamber and holding at that temperature for one hour. In performing the invention a range of heat treatment temperatures may be used from 1100°C to 1200°C inclusive, according to the solution heat treatment temperature normally used for the superalloy article 26. Although different diffusion times could be used, for example up to six hours may be used, it was judged that one hour was sufficient at this range of temperatures for the platinum to be properly combined with the superalloy substrate 27 without prematurely aging the superalloy substrate 27.

The microstructure of the superalloy substrate 27 generally comprises two phases, as seen more clearly in Figures 4 these being a gamma phase matrix 44 and a gamma prime phase 46 in the gamma phase matrix 44. The gamma prime phase 46 forms a reinforcement in the gamma phase matrix 44. The heat treatment of the platinum layer 38 on the superalloy substrate 27 causes aluminium in the superalloy substrate 27 to be diffused outwards towards the platinum layer 45 on the surface of the superalloy substrate 27. This results in the formation of a platinum enriched gamma phase 48 and a platinum enriched gamma prime phase 50 in the outer surface layer of the superalloy article 26. The aluminium in the platinum enriched outer surface layer 38 of the superalloy article 26 is available for formation of alumina 40. It is to be noted that the region 52 of the superalloy article 26 immediately below the platinum enriched outer surface layer 38 does not have any gamma prime phase 46. The heat treatment causes the aluminium in this gamma prime phase to move to the platinum layer 38 and hence breaks down the gamma prime phase due to aluminium's greater chemical affinity for platinum. It is to be noted that some of the regions of platinum enriched gamma prime phase 50 in the platinum enriched outer surface layer 38 have distinct promontories, or pegs, which have grown inwardly into the region 52 of the superalloy article 26. It is believed that these platinum enriched gamma prime phase pegs 54 grow into the superalloy article 26 and draw the aluminium from the gamma prime phase regions in the superalloy article 26. Thus it can be seen that the platinum in the platinum layer only diffuses into the superalloy article 26 in these distinct platinum enriched gamma prime pegs 54, rather than as a continuous band of platinum. The extent of growth of the platinum enriched gamma prime pegs 54 is sensitive to the thickness of the platinum layer and the diffusion temperature. The platinum levels in the platinum enriched gamma prime phase 48 and the platinum enriched gamma phase 50 are about equal, showing that both of these phases are equally favoured. It is also to be noted that if there is sufficient aluminium in the superalloy article a continuous platinum enriched gamma prime phase forms on a platinum enriched gamma phase matrix containing platinum enriched gamma prime phases. Furthermore there is always a layer of platinum enriched gamma phase immediately underneath the alumina layer as platinum enriched gamma prime phase breaks down to the platinum enriched gamma phase when it loses aluminium to form alumina. To enhance the thermal barrier coating adhesion to the superalloy article 26 it is desirable to ensure phase stability within the platinum enriched gamma phase 48 and the platinum enriched gamma prime phase 50. The stability is achieved by appropriate selection of the platinum thickness within the specified heat treatment temperature range of above 1100°C to 1200°C. In addition it is important to ensure that any phase changes which occur in operation, within a gas turbine engine, result in small volume changes. This is achieved by control of the composition of the platinum enriched gamma phase 48 and platinum enriched gamma prime phase 50. The composition of the platinum enriched gamma and platinum enriched gamma prime phases are balanced, i.e. the compositions are closely matched, and any changes from the platinum enriched gamma prime phase to the platinum enriched gamma phase only results in small volume changes.

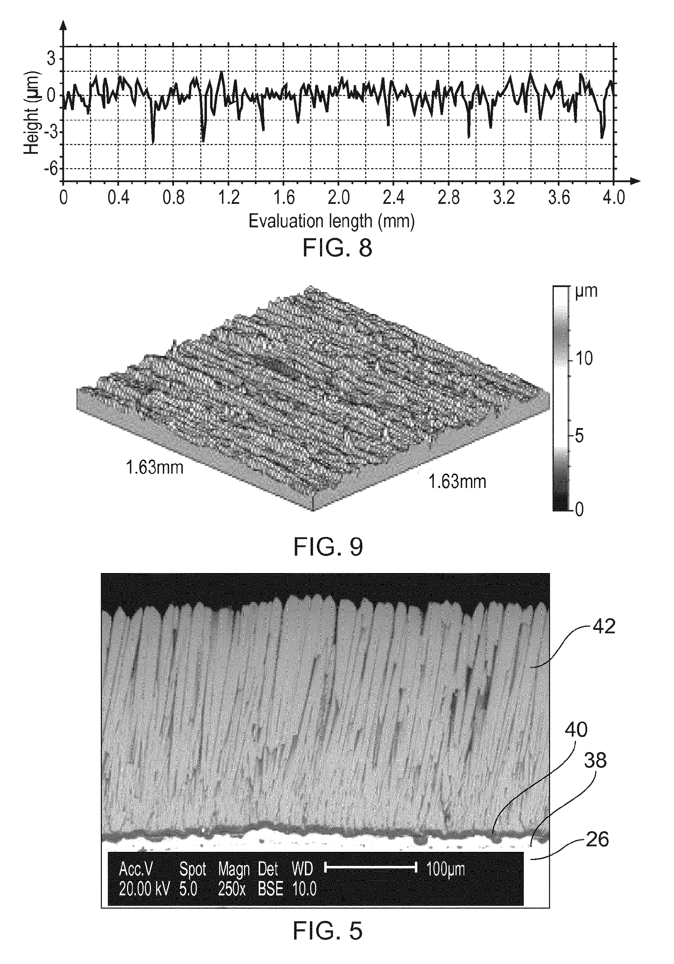

After heat treatment the platinum enriched surface layer 38 still has a microstructure comprising a patterned surface including a plurality of pockets 35, a plurality of projections, protuberances or spikes, 39 extending away from the superalloy article 26 and a plurality of ridges 39. A layer of a ceramic 42 consisting of partially stabilized zirconia (in this case, zirconia containing 8% by weight of yttria) was applied by electron beam physical vapour deposition (EBPVD). This ceramic coating is available from Turbine Surface Technology Limited (UK), Unit 13A, Little Oak Drive, Annesley, Nottinghamshire, NG15 0DR, United Kingdom. For the electron beam physical vapour deposition (EBPVD) process, the superalloy article 26 was initially held in a preheating chamber and preheated to a temperature of about 1000°C at a pressure of about $10^{-5}$ Torr. It was then immediately transferred to an electron beam coating chamber, where it continued to be held for coating at 1000°C at a pressure of $10^{-2}$ to $10^{-3}$ Torr, in an atmosphere consisting of argon and oxygen. The presence of oxygen at an elevated temperature during the EBPVD coating process made it inevitable that a thin oxide layer 40 formed on the surface of the platinum enriched outer layer 38 of the superalloy article 26 which comprises the platinum enriched gamma phase 48 and platinum enriched gamma prime phase 50. The oxide layer 40 was covered by the ceramic layer 42 and the oxide layer 40 predominantly comprises alumina. The superalloy article 26, the platinum enriched surface layer 38, the thermally grown oxide layer 40 and the ceramic coating 42 are shown in Figure 5. The columnar ceramic grains 41 extend substantially perpendicularly to the surface of the superalloy substrate 27 from the oxide layer 40. The thin oxide layer 50 has a thickness of about 0.5μm as manufactured, but may be up to about 1μm depending upon the manufacturing process. The ceramic coating 42 has a thickness of typically between 50μm and 200μm but may taper to zero thickness at regions where a ceramic coating is not required.

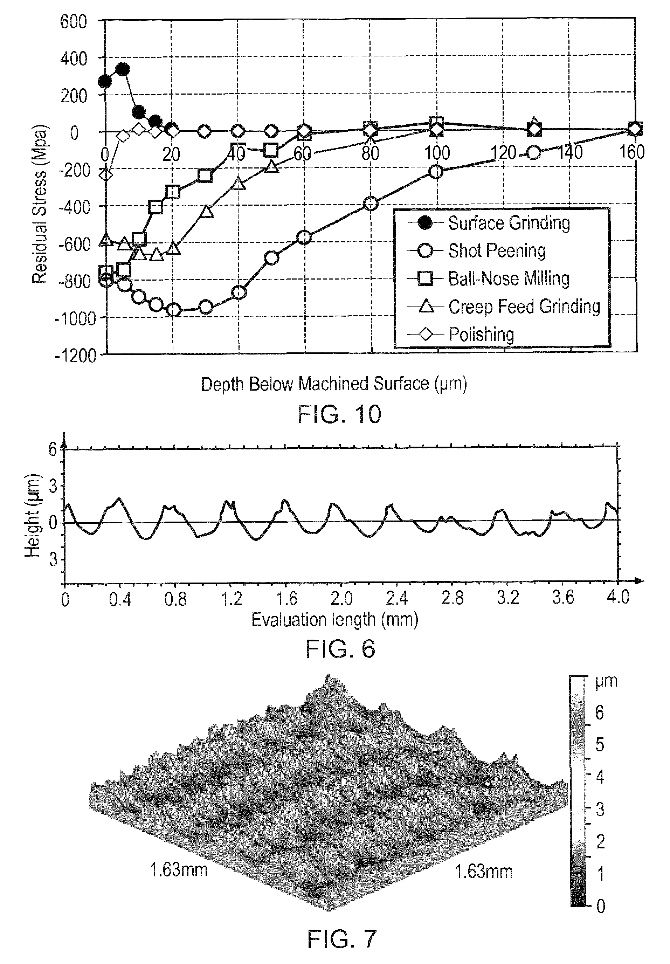

The machining of the surface of the superalloy article 26 using a ball nose milling tool produces the uniform pattern of pockets 35, projections 37 and ridges 39 in the surface of the superalloy article 26. The ball nose milling metal removal process introduces a compressive residual stress into the machined surface and the subsurface layers of the superalloy article 26 and as a consequence, crack initiation from the milled surface layers prior to application of the bond coating 38 and ceramic coating 42 is reduced or prevented due to the blunt shape of the pockets 35. The uniform pattern of part spherical/circular pockets 35, projections 37 and ridges 39 in the surface of the superalloy article 26 hinder crack initiation, due to the compressive residual stress in the surface layers of the superalloy article 26 and reduce the stress in the ceramic coating 42 due to the increased surface area for contact and adherence/bonding between the ceramic coating 42 and the metallic material of the bond coating 38. The residual compressive stress in the surface layers of the superalloy article 26 may be controlled, or selected, by controlling the ball nose milling process by controlling, e.g. adjusting the dimensions of the pockets, projections and ridges. The dimensions of the pockets 35, projections 37 and ridges 39 may be controlled by changing the ball nose milling tool diameter, the number of flutes, the cutting edge geometry of the ball nose milling tool, the cutting angle, the cutting federate step over, the cutting speed and the depth of cut. The projections 37 and ridges 39 are disruptive features which improve the spallation properties of the ceramic coating 42 by introducing a controlled degree of tortuosity into the surface of the thermally grown oxide layer 40. This may arrest delamination of the thermally grown oxide layer 40 and hence improve the spallation life, the time to spallation, of the ceramic coating 42. There is slight increase in the contact area between the oxide layer 40 and the metallic bond coating 38 producing a corresponding localised reduction in the stress in the oxide layer 40. The rounded shape of the pockets 35, shown in Figures 6 and 7, also results in localised reduction in stress, and so prevents crack initiation which is in contrast to the sharp micro-notch shape, shown in Figures 8 and 9, produced by surface grinding which may act as stress concentrators and thus crack initiation sites.

Alternatively, the machining of the surface of the superalloy article 26 using a ball nose milling tool produces the uniform pattern of grooves 35 and ridges 39 in the surface of the superalloy article 26. The ball nose milling metal removal process introduces a compressive residual stress into the machined surface and the subsurface layers of the superalloy article 26 and as a consequence, crack initiation from the milled surface layers prior to application of the bond coating 38 and ceramic coating 42 is reduced or prevented due to the blunt shape of the pockets 35. The uniform pattern of circular cross-section grooves 35 and ridges 39 in the surface of the superalloy article 26 hinder crack initiation, due to the compressive residual stress in the surface layers of the superalloy article 26 and reduce the stress in the ceramic coating 42 due to the increased surface area for contact and adherence/bonding between the ceramic coating 42 and the metallic material of the bond coating 38. The residual compressive stress in the surface layers of the superalloy article 26 may be controlled, or selected, by controlling the ball nose milling process by controlling, e.g. adjusting the dimensions of the grooves and ridges.

The heights of the projections 37 and the ridges 39 are determined by the ball nose milling tool and in particular by the cutter diameter D, and the size of the step over $a_e$, which is the distance between adjacent cuts, see Figure 13. The theoretical height $R_{th}$ of the ridges 39 may be calculated from the formula:-

$$R_{th} = D/2 - \sqrt{((D^2 - a_e^2)/4)}$$

The flutes of the milling tool are helical grooves on the ball end milling tool which run from the end of the ball end milling tool to a certain distance, the flute length, from the end of the ball end milling tool. There are two or more flutes on a milling tool and each flute has one or more sharp edges, also known as teeth, which cut material. Multi-fluted milling tools have higher metal removal, or cutting, rates.

Figures 6 and 7 show examples of two dimensional and three dimensional topography plots for a surface machined using high speed ball nose milling. Figures 6 and 7 show a uniform distribution of pockets in the surface of the superalloy article 26. In comparison figures 8 and 9 show examples of two dimensional and three dimensional topography plots for a surface machined using surface grinding. Figures 8 and 9 show a ground surface with sharp notches which, combined with tensile residual stress, may act as micro-crack initiation sites and which restrict adherence of the bond coating to the thermal barrier coating.

In the examples of Figures 6 and 7 the ball nose milling produces a surface peak to peak value for individual line scan of greater than or equal to 0.5μm and less than or equal to 2μm. In the examples of Figures 6 and 7 the spacing between the centres of adjacent pockets 35 is about 0.4μm, the spacing between adjacent projections 37 is about 0.4μm and the height of the projections 37 above the centres of the pockets 35 is about 4μm. The ball nose milling may be used to produce surface roughness of a required range, to produce spacings between the centres of the pockets 35, to produce spacings between projections 37 and/or to produce heights of projections 37 above the centres of the pockets 35 within a required range. The pockets 35 shown in Figure 7 were produced by ball nose milling with a cutter tilt angle of 45°.

In the case of a pattern comprising grooves 35 and ridges 39 the spacing between the centres of adjacent grooves 35 is about $0.4\mu m$, the spacing between adjacent ridges 39 is about $0.4\mu m$ and the height of the ridges 39 above the centres of the grooves 35 is about $4\mu m$. The ball nose milling may be used to produce surface roughness of a required range, to produce spacings between the centres of the grooves 35, to produce spacings between ridges 39 and/or to produce heights of ridges 39 above the centres of the grooves 35 within a required range.

Figure 10 shows an example of the residual stress versus depth introduced into a metallic article due to different machining process. The different machining process included polishing, ball nose milling, surface grinding, shot peening and creep feed grinding. It is clear from the graph that the surface grinding introduces a tensile residual stress in the surface layers of the metallic article and that a shot peening process introduces a compressive residual stress in the surface layers of the metallic article. It is also clear that the ball nose milling introduces the greatest compressive residual stress in the surface layers of the metallic article except for the shot peening process. The ball nose milling introduces compressive residual stress of about 800MPa at the surface of the metallic article and which is at least 500MPa at depths less than $10\mu m$ from the surface of the metallic article. This compressive residual stress reduces the formation of vacancies within the bond coating during heat treatment leading to a reduced diffusion rate of deleterious elements, e.g. titanium and sulphur, through the bond coating to and into the thermally grown oxide layer. The extent of the benefit is not understood, but it is theorised to act on the spallation life of the thermal barrier coating with similar mechanisms as a reduction in the sulphur content of the metallic, superalloy, article. This is based on established high temperature creep models where vacancy formation is dependent upon the applied tensile stress, see Weertman, Johannes, "Theory of high temperature intercrystalline fracture under static or fatigue loads, with or without irradiation damage", Metallurgical Transactions, August 1974, Volume 5, Issue 8, pp 1743-1751.

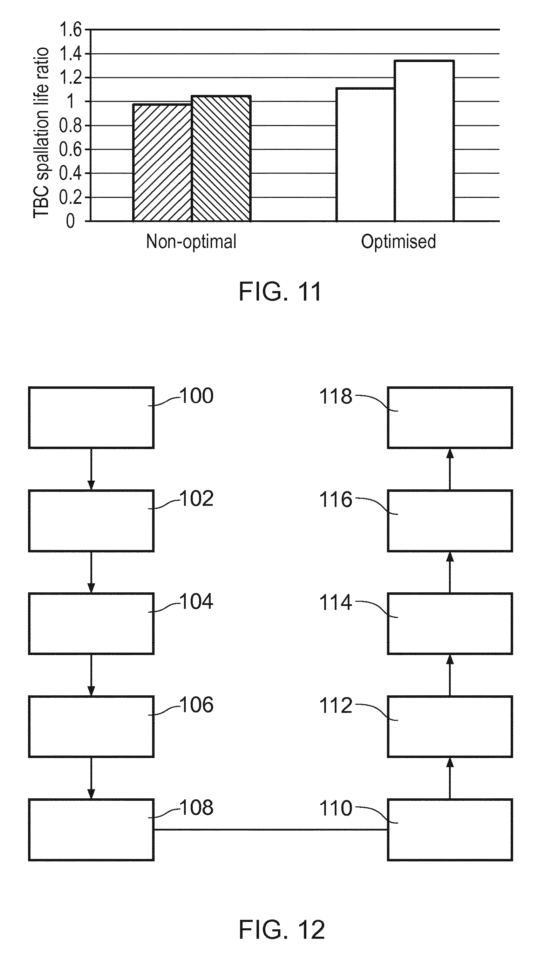

Figure 11 compares the relative spallation life for a thermal barrier coating according to the present disclosure (optimised) and a prior art thermal barrier coating (non-optimal) and figure 11 indicates that the spallation life of a thermal barrier coating according to the present disclosure is greater than the spallation life of a prior art thermal barrier coating and on average is about 23% greater.

Test buttons of a nickel based single crystal superalloy, CMSX4, were produced by single crystal casting. Some of the test buttons were machined by milling and some of the test buttons were left un-machined. The surfaces of the machined test buttons were characterised, measured, using a contactless infinite focus microscope which is able to measure a range of linear roughness parameters (e.g. Ra) and area roughness parameters (e.g. Sa and Sdr). The milled and un-machined test buttons were then grit blasted and cleaned using wet processes commonly used by those skilled in the art of plating. The grit blasting was carefully controlled using a blasting pressure of 30psi (0.2MPa), 300mm distance to the surface and the use of 220 mesh alumina grit. A layer of platinum was then applied by electroplating to a thickness of $12\mu m$ and then heat treated at 1150°C for 1 hour to diffuse the platinum into the CMSX4 nickel based superalloy. Prior to deposition of a thermal barrier coating the surface of the platinum enriched layer of the nickel based superalloy was lightly grit blasted and cleaned with alcohol. A thermal barrier coating comprising 7wt% yttria stabilised zirconia was applied using standard electron beam physical vapour deposition (EBPVD) process to a thickness of $200\mu m$. A spallation test to determine the spallation life of the thermal barrier coatings used a thermal cycle test comprising a 3 hour soak at a temperature of 1190°C followed by cooling to ambient temperature. The test buttons were inspected after each 3 hour cycle and failure, or spallation, was declared when 20% of the thermal barrier coating was lost from the test button.

In the examples of milled test buttons improvements in the spallation life of the thermal barrier coating were observed with an 8mm diameter, 10 flute, ball nose milling tool with a cutting tilt angle of 45° and with a step over between and including 0.2mm and 0.4mm, a cutter speed of between and including 50m/min and 100m/min, and a feed rate of between and including 0.05mm/tooth and 0.1 mm/tooth. A range of milling parameters and a range of ball nose milling tool geometries may be used to produce the required surface texture and resulting improvement in spallation life of the thermal barrier coating.

Figure 12 is a flow chart for a method of manufacturing a thermal barrier coated article according to the present disclosure. In the case of turbine blade and turbine vane metallic articles, turbine blades and turbine vanes are manufactured by casting the molten superalloy into a mould and solidifying the superalloy in the mould 100. The turbine blades and turbine vanes may be solidified conventionally to form an equi-axed microstructure, may be directionally solidified to form a directionally solidified microstructure or may be directionally solidified to form a single crystal structure. The turbine blades and turbine vanes are hollow and have internal passages for the flow of coolant there-through and have a wall defining the shape of the aerofoil. The three dimensional external profile, aerofoil profile, of an as-cast turbine blade or turbine vane is measured 102 using a suitable technique such as by scanning structured light, a laser beam or coordinate measuring machine over the surface of the aerofoil of the turbine blade or turbine vane. Alternatively, the turbine blades and turbine vanes are manufactured from a suitable powdered superalloy by building up layer by layer using a laser, or an electron beam, to melt and sinter or fuse the powdered superalloy into a monolithic structure. The turbine blade or turbine vane may have an equi-axed, a directionally solidified or a single crystal structure with appropriate control of the solidification of the molten powdered superalloy. The thickness of the wall defining the aerofoil is measured 104 using a suitable technique such as by scanning an ultrasonic probe or an X-ray probe over the surface of the aerofoil of the turbine blade or turbine vane or by performing a CT (X-ray Computed Tomography) scan of the turbine blade or turbine vane. The measured three dimensional external profile, aerofoil profile, of the turbine blade, or turbine vane, is compared to a required three dimensional external profile, aerofoil profile, of the turbine blade, or turbine vane, e.g. to a CAD definition of the turbine blade, or turbine vane, and the measured thickness of the wall defining the aerofoil of the turbine blade, or turbine vane, is compared to a required thickness of the wall defining the aerofoil of the turbine blade or turbine vane, e.g. to the CAD definition of the turbine blade or turbine vane 106. The part wall thickness section is compared to the nominal requirements in a virtual environment by comparing a three dimensional scanned model of the turbine blade, or turbine vane, with the CAD definition of the turbine blade, or turbine vane, which is biased, or weighted, to the core position/nominal wall thickness. In other words the core passage or core passages of the turbine blade, or turbine vane, is/are aligned with the corresponding features in the CAD definition by manipulating, e.g. translating and/or rotating, the three dimensional scanned model of the turbine blade, or turbine vane. When the three dimensional scanned model and CAD definition are aligned, the three dimensional external profile are examined and a new finished part model and a unique numerically controlled machining programme is generated to create the a three dimensional external profile of the turbine blade, or turbine vane, which match the nominal dimensional values in the CAD model of the turbine blade, or turbine vane, see step 108. A tool path is determined for machining the external surface of the aerofoil of the turbine blade or turbine vane to optimise the aerofoil profile of the turbine blade or turbine vane, to optimise the wall thickness of the aerofoil of the turbine blade or turbine vane, relative to the internal surface, or surfaces, of the aerofoil which were defined by one or more cores used during the casting process, and to provide a patterned surface for optimum thermal barrier coating performance 110. The dimensions of the turbine blade, or turbine vane, are measured and compared to the CAD definition of the turbine blade, or turbine vane, and the surface finish, e.g. the roughness and topography, of the turbine blade, or turbine vane, is measured and the surface of the turbine blade, or turbine vane, is visually inspected 112. The patterned surface of the surface of the turbine blade or turbine blade is cleaned and optionally grit blasted as discussed above 114. The bond coating is applied to the patterned surface of the turbine blade or turbine vane 116 and then the thermal barrier coating is applied to the bond coating 118.

Although the present disclosure has been described with reference to ball nose milling, e.g. using a ball nose milling tool, it may be equally possible to use bull nose milling, e.g. using a bull nose milling tool. The present disclosure may also use other suitable milling processes, e.g. milling tools, for example a straight milling tool or a tapered milling tool. Thus, in the case of a tapered milling tool the surface of the metallic, superalloy, article may comprise a plurality of conical pockets and/or a plurality of elongated pockets each having two part conical shaped ends and a v-shaped cross-section groove between the two part conical shaped ends and adjacent elongated pockets separated by ridges and/or a plurality of v-shaped cross-section grooves separated by ridges. It may also be possible to use different milling processes at different regions of the surface of the metallic, superalloy, article for example any two or more of using a ball nose milling tool, a bull nose milling tool, a tapered milling tool and a straight milling tool. For example it may be possible to use a ball nose milling tool at a first region and a tapered milling tool at a second region to produce pockets and/or grooves with different shapes at the different, first and second, regions.

The present disclosure may use either conventional milling, e.g. up cutting, or climb milling, e.g. down cutting. The present disclosure may use milling with a cutter lead angle of 0° or any suitable cutter lead angle between and including - 60° and +60°. The present disclosure may use milling with a cutter tilt angle of 0° or any suitable cutter tilt angle between and including -60° and +60°. Cutter tilt angle is an angle perpendicular to the feed direction and cutter lead angle is an angle in the feed direction.

The patterned surface of the superalloy article 26 may include pockets 35 which are advantageously machined such that they are angled in the general flow direction A of the gases over the surface of the superalloy article 26. In the case of a turbine blade, or a turbine vane, the pockets 35 would be angled axially, in the chordal direction of the aerofoil portion 28 of the turbine blade 26, or turbine vane and be angled axially on the platform portions 30 of the turbine blade 26, or turbine vane, as shown in figures 14 and 16. A first set of the ridges 39 are arranged parallel to each other and are arranged generally transverse, e.g. perpendicular, to the general flow direction A of the gases over the surface of the superalloy article 26. The first set of ridges 39 are also angled in the general flow direction A of the gases over the surface of the superalloy article 26. The pockets 35 and the first set of ridges 39 are arranged at an angle greater than 0° and less than 60°, for example at an angle of 45°. In the case of a combustion chamber wall or combustion chamber tile or combustion chamber segment the grooves and ridges would extend axially. In a turbine blade 26, or a turbine vane, the pockets 35 and ridges 39 at each region of the surface of the aerofoil portion 28 and platform portion 30 are angled in the local flow direction of the gases over the surface of the turbine blade 26 or turbine vane, except for regions of the surface where there are secondary flows. Thus, the pockets 35 are asymmetrical and the centres, or bottoms, of the pockets 35 are displaced in an upstream direction relative to the local flow direction of the gases over the surface of the superalloy article 26, the ridge 39 downstream of the bottom of each pocket 35 is angled in the local flow direction and is longer than the ridge 39 upstream of the bottom of respective pocket 35.

Some of the pockets 35 may advantageously be machined such that they are angled in the opposite direction to a secondary flow direction B of the gases over the surface of the superalloy article 26 as shown in figure 17. A first set of the ridges 39 are arranged parallel to each other and are arranged generally transverse, e.g. perpendicular, to the secondary flow direction B of the gases over the surface of the superalloy article 26. The first set of ridges 39 are also angled in the opposite direction to the secondary flow direction B of the gases over the surface of the superalloy article 26. The pockets 35 and the first set of ridges 39 are arranged at an angle greater than 0° and less than 60°, for example at an angle of 45°. Thus, the pockets 35 are asymmetrical and the centres, or bottoms, of the pockets 35 are displaced in a downstream direction relative to the secondary flow direction B of the gases over the surface of the superalloy article 26, the ridge 39 upstream of the bottom of each pocket 35 is angled in the opposite direction to the secondary flow direction B and is longer than the ridge 39 downstream of the bottom of respective pocket 35.

The patterned surface of the superalloy article 26 may include circular cross-section grooves 35 and ridges 39 which are advantageously machined such that they are angled in the general flow direction A of the gases over the surface of the superalloy article 26. In the case of a turbine blade 26, or a turbine vane, the grooves 35 and ridges 39 would be angled axially, in the chordal direction of the aerofoil portion 28 of the turbine blade 26, or turbine vane and be angled axially on the platform portions 30 of the turbine blade 26, or turbine vane, as shown in figures 14 and 16. The grooves 35 and ridges 39 are arranged parallel to each other and are arranged generally transverse, e.g. perpendicular, to the general flow direction A of the gases over the surface of the superalloy article 26. The grooves 35 and ridges 39 are also angled in the general flow direction A of the gases over the surface of the superalloy article 26. The grooves 35 and the ridges 39 are arranged at an angle greater than 0° and less than 60°, for example at an angle of 45°. In the case of a combustion chamber wall or combustion chamber tile or combustion chamber segment the grooves and ridges would extend axially. This would improve the cooling effectiveness and hence increase the working life of the superalloy article 26. In a turbine blade 26, or a turbine vane, the grooves 35 and ridges 39 at each region of the surface of the aerofoil portion 28 and platform portion 30 are angled in the local flow direction of the gases over the surface of the turbine blade 26 or turbine vane, except for regions of the surface where there are secondary flows. Thus, the grooves 35 are asymmetrical and the centres, or bottoms, of the grooves 35 are displaced in an upstream direction relative to the local flow direction of the gases over the surface of the superalloy article 26, the ridge 39 downstream of the bottom of each groove 35 is angled in the local flow direction and is longer than the ridge 39 upstream of the bottom of respective groove 35.

Some of the grooves 35 and ridges 39 may advantageously be machined such that they are angled in the opposite direction to a secondary flow direction B of the gases over the surface of the superalloy article 26 as shown in figure 17. The grooves 35 and ridges 39 are arranged parallel to each other and are arranged generally transverse, e.g. perpendicular, to the secondary flow direction B of the gases over the surface of the superalloy article 26. The grooves 35 and ridges 39 are also angled in the opposite direction to the secondary flow direction B of the gases over the surface of the superalloy article 26. The grooves 35 and the ridges 39 are arranged at an angle greater than 0° and less than 60°, for example at an angle of 45°. Thus, the grooves 35 are asymmetrical and the centres, or bottoms, of the grooves 35 are displaced in a downstream direction relative to the secondary flow direction B of the gases over the surface of the superalloy article 26, the ridge 39 upstream of the bottom of each groove 35 is angled in the opposite direction to the secondary flow direction B and is longer than the ridge 39 downstream of the bottom of respective groove 35.

It is to be noted that the surface of the ceramic coating remote from the superalloy article replicates the patterned surface of the superalloy article and thus has pockets, grooves, ridges and projections but to a lesser degree.

The patterned surface of the superalloy article, e.g. pockets and projections and/or grooves and ridges, may be used without a thermal barrier coating, e.g. without a bond coating and a ceramic coating, and the patterned surface may be arranged as described above such that it is angled in the general flow direction of the gases over the surface of the superalloy article in some regions and it is angled in the opposite direction to a secondary flow direction of the gases over the surface of the superalloy article.

The patterned surface of the superalloy article may be different at different regions of the surface of the superalloy article to produce different amounts of compressive residual stress into the superalloy article at the different regions. Regions of the surface of the superalloy article corresponding to regions of the superalloy article subject to high tensile loads/stress in operation due to centrifugal forces and/or exposure to high temperatures are machined to produce greater compressive residual stress than other regions of the surface of the superalloy article corresponding to regions of the superalloy article subject to lower tensile loads/stress in operation due to centrifugal forces and/or exposure to high temperatures. The regions of the surface of the superalloy article corresponding to regions of the superalloy article subject to high tensile loads/stress in operation due to centrifugal forces and/or exposure to high temperatures are machined to produce greater compressive residual stress to reduce the resulting tensile stress in these regions of the superalloy article and hence increase the working life of the superalloy article. The regions of the surface of the superalloy article corresponding to regions of the superalloy article subject to high tensile loads/stress in operation are machined such that the pockets and projections and/or the grooves and ridges have smaller dimensions than the pockets and projections and/or the grooves and ridges in the regions of the superalloy article subject to lower tensile loads/stress in operation. In the case of a patterned surface comprising pockets and projections the spacing between the centres of adjacent pockets, the spacing between adjacent projections and the height of the projections above the centres of the pockets are smaller in the regions of the surface of the superalloy article corresponding to regions of the superalloy article subject to high tensile loads/stress in operation than in the regions of the superalloy article subject to lower tensile loads/stress in operation. In the case of a patterned surface comprising grooves and ridges the spacing between the centres of adjacent grooves, the spacing between adjacent ridges and the height of the ridges above the centres of the grooves are smaller in the regions of the surface of the superalloy article corresponding to regions of the superalloy article subject to high tensile loads/stress in operation than in the regions of the superalloy article subject to lower tensile loads/stress in operation.

Thus, the patterned surface of the superalloy article may be different at different regions of the surface of the superalloy to produce different amounts of compressive residual stress into the superalloy article at the different regions and may be different at different regions so as to be aligned with flow direction of the gases over the surface of the superalloy article or to be misaligned with the secondary flow direction of gases over the surface of the superalloy article. In a region of the surface of the superalloy article corresponding to regions of the superalloy article subject to high tensile loads/stress in operation the patterned surface has relatively small dimensions, as discussed above, and either has the patterned surface aligned with the flow direction of the gases over the surface of the superalloy article or has the patterned surface misaligned with the secondary flow direction of gases over the surface of the superalloy article, as discussed above. In a region of the surface of the superalloy article corresponding to regions of the superalloy article subject to lower tensile loads/stress in operation the patterned surface has relatively large dimensions, as discussed above, and either has the patterned surface aligned with the flow direction of the gases over the surface of the superalloy article or has the patterned surface misaligned with the secondary flow direction of gases over the surface of the superalloy article, as discussed above.

Although the present disclosure has been described with reference to providing a layer of platinum onto the surface of the metallic, superalloy, substrate, it is equally possible to provide a layer of any platinum-group metal, for example palladium, rhodium, iridium, however platinum is the preferred platinum-group metal and hence provide a platinum-group metal enriched outer layer on the metallic, superalloy, article. It may be possible to use a combination of two or more of the platinum-group metals, for example platinum and rhodium, platinum and palladium, palladium and rhodium or platinum, palladium and rhodium etc. in the platinum-group metal enriched outer layer on the metallic, superalloy, article.

Although the present disclosure has been described with reference to simply providing a platinum-group metal enriched outer, or surface, layer on the metallic, superalloy, substrate it may be equally possible to subsequently deposit a layer of aluminium on the platinum-group metal enriched outer, surface, layer on the metallic, superalloy, article, by pack aluminising, vapour aluminising, slurry aluminising or other suitable method, and then heat treating the aluminium coated platinum-group metal enriched outer, surface, layer on the metallic, superalloy, article to inter-diffuse the aluminium and the platinum-group metal enriched outer layer on the metallic, superalloy, article to create a platinum-group metal aluminide coating on the metallic, superalloy, article before the ceramic coating is deposited onto the thin oxide layer on the platinum-group metal enriched outer layer on the metallic, superalloy, article. The platinum-group metal aluminide coating may also include additions of chromium, hafnium, silicon and/or zirconium.

Although the present disclosure has referred to a platinum-group metal enriched outer layer or a platinum-group metal aluminide coating on the metallic, superalloy, article it is equally possible to enrich the metallic article with aluminium to form an aluminium enriched outer layer on the metallic article and creating the thin adherent layer of oxide on the aluminium enriched outer layer of the metallic article. The forming of the aluminium enriched outer layer may comprise forming an aluminide layer on the metallic article and creating the thin adherent layer of oxide on the aluminide layer of the metallic article. The metallic, superalloy, article may be enriched with aluminium by depositing a layer of aluminium on the metallic, superalloy, article, by pack aluminising, vapour aluminising, slurry aluminising, physical vapour deposition (PVD) or other suitable method, and then heat treating the aluminium coating on the metallic, superalloy, article to inter-diffuse the aluminium and the metallic, superalloy, article to create an aluminium enriched outer layer or an aluminide coating on the metallic, superalloy, article before the ceramic coating is deposited onto the thin oxide layer on the metallic, superalloy, article. The aluminium enriched outer layer or the aluminide coating may also include additions of chromium, hafnium, silicon and/or zirconium.

Additionally, if the metallic, superalloy, article consists of a sufficient level of aluminium to form an alumina layer on the surface of the metallic, superalloy, article then it may be possible to dispense with a bond coating and simply deposit the ceramic thermal barrier coating directly onto thin oxide layer on the metallic, superalloy, article.

Although the present disclosure has been described with reference to the use of electron beam physical vapour deposition (EBPVD) to produce columnar ceramic grains in the ceramic coating it is possible to use any other suitable physical vapour deposition process which produces columnar ceramic grains in the ceramic coating, e.g. plasma assisted electron beam physical vapour deposition (PAEBPVD), a combination of electron beam physical vapour deposition and plasma assisted electron beam physical vapour deposition to produce layers in the columnar ceramic grains, plasma spray physical vapour deposition (PSPVD) or directed vapour deposition (DVD). The present disclosure is also applicable to any other deposition process which produces columnar ceramic grains in the ceramic coating, e.g. solution precursor plasma spraying (SPPS) or suspension plasma spraying (SPS).

The superalloy article may comprise CMSX4 a nickel based superalloy. CMSX4 is a trade name of the Cannon-Muskegon Corporation of 2875 Lincoln Street, Muskegon, Michingan, MI 49443-0506, USA. CMSX4 has a nominal composition of 6.4wt% tungsten, 9.5wt% cobalt, 6.5wt% chromium, 3.0wt% rhenium, 5.6wt% aluminium, 6.5wt% tantalum, 1.0wt% titanium, 0.1wt% hafnium, 0.6wt% molybdenum, 0.006wt% carbon and the balance nickel plus incidental impurities. The superalloy article may comprise low sulphur CMSX4 which has the same nominal composition but has less than 1ppm by weight sulphur and preferably has less than 0.5ppm by weight sulphur. The superalloy article may be a nickel based superalloy, a cobalt based superalloy, an iron based superalloy, a low sulphur nickel based superalloy, a low sulphur cobalt based superalloy or a low sulphur iron based superalloy. The advantage of using a low sulphur superalloy article is that it provides a further increase in the working life of the ceramic coating.

Although the present disclosure has been described with reference to a ceramic coating comprising yttria stabilised zirconia, it is equally applicable to other suitable ceramic coatings, for example zirconia stabilised with one or more other ceramics e.g. yttria and erbia stabilised zirconia, yttria and gadolinia stabilised zirconia or yttria, erbia and gadolinia stabilised zirconia or the ceramic coating may comprise at least one layer of two, three or all of these ceramics. The ceramic coating may for example comprise at least one layer of yttria stabilised zirconia and at least one layer of yttria and erbia stabilised zirconia, at least one layer of yttria stabilised zirconia and at least one layer of yttria and gadolinia stabilised zirconia, at least one layer of yttria stabilised zirconia and at least one layer of yttria, erbia and gadolinia stabilised zirconia, at least one layer of yttria and erbia stabilised zirconia and at least one layer of yttria and gadolinia stabilised zirconia, at least one layer of yttria and erbia stabilised zirconia and at least one layer of yttria, erbia and gadolinia stabilised zirconia or at least one layer of yttria and gadolinia stabilised zirconia and at least one layer of yttria, erbia and gadolinia stabilised zirconia. The ceramic coating may comprise at least one layer of yttria stabilised zirconia, at least one layer of yttria and erbia stabilised zirconia and at least one layer of yttria and gadolinia stabilised zirconia. The ceramic coating may comprise at least one layer of yttria stabilised zirconia, at least one layer of yttria and erbia stabilised zirconia and at least one layer of yttria, erbia and gadolinia stabilised zirconia. The ceramic coating may comprise at least one layer of yttria stabilised zirconia, at least one layer of yttria and gadolinia stabilised zirconia and at least one layer of yttria, erbia and gadolinia stabilised zirconia. The ceramic coating may comprise at least one layer of yttria and gadolinia stabilised zirconia, at least one layer of yttria and erbia stabilised zirconia and at least one layer of yttria, erbia and gadolinia stabilised zirconia. The ceramic coating may comprise at least one layer of yttria stabilised zirconia, at least one layer of yttria and erbia stabilised zirconia, at least one layer of yttria and gadolinia stabilised zirconia and at least one layer yttria, erbia and gadolinia stabilised zirconia.

Although the present disclosure has referred to a turbine blade and a turbine vane it is equally applicable to a turbine shroud, an abradable seal, a combustion chamber wall or a combustion chamber tile.

Although the present disclosure has been described with reference to a metallic, superalloy, article for a turbofan gas turbine engine it is equally applicable to a metallic, superalloy, article for a turbojet gas turbine engine, a turbo-propeller gas turbine engine or a turbo-shaft gas turbine engine and is applicable to aero gas turbine engines, marine gas turbine engines, automotive gas turbine engines or industrial gas turbine engines. The present disclosure is equally applicable to metallic, superalloy, articles for other turbomachines, e.g. steam turbines or other apparatus requiring metallic, superalloy, articles with thermal barrier coatings.

It will be understood that the invention is not limited to the embodiments above-described and various modifications and improvements can be made without departing from the concepts described herein. Except where mutually exclusive, any of the features may be employed separately or in combination with any other features and the disclosure extends to and includes all combinations and subcombinations of one or more features described herein.

## Claims

1. A method of applying a thermal barrier coating to a metallic article (26) comprising the steps of:-

   (a) ball nose milling or bull nose milling the surface of the metallic article (26) to produce a pattern in the surface of the metallic article (26) and to produce a compressive residual stress in the surface and subsurface layers of the metallic article (26), the pattern comprising a plurality of pockets (35) and a plurality of projections (37) on the surface of the metallic article (26) and/or a plurality of grooves (35) and a plurality of ridges (39) on the surface of the metallic article (26),
   (b) creating a thin adherent layer of oxide (40) on the metallic article (26), and
   (c) applying a ceramic coating (42) to the oxide layer (40) on the surface of the metallic article (26) such that the ceramic coating (42) deposits on the surface of the metallic article (26) in the pockets (35) and on and around the projections (37) and/or in the grooves (35) and on the ridges (39), applying the ceramic coating (42) as a plurality of columnar ceramic grains (41) extending substantially perpendicularly away from the metallic article (26), the columnar ceramic grains (41) extending from the oxide layer (40) on the metallic article (26).

2. A method of applying a thermal barrier coating to a metallic article as claimed in claim 1 wherein step (b) comprises providing a bond coating (38) on the metallic article (26) and creating the thin adherent layer of oxide (40) on the bond coating (38), and step (c) comprises applying the ceramic coating (42) to the oxide layer (42) on the surface of the bond coating (38).

3. A method of applying a thermal barrier coating to a metallic article as claimed in claim 2 wherein step (b) comprises depositing the bond coating (38) by applying the bond coating (38) by electroplating and then heat treating the bond coating (38).

4. A method of applying a thermal barrier coating to a metallic article as claimed in claim 2 or claim 3 wherein step (b) comprises applying a layer of platinum-group metal to the metallic article (26), heat treating the platinum-group-metal coated metallic article to diffuse the platinum-group metal into the metallic article to create a platinum-group metal enriched outer layer (38) on the metallic article (26), and creating the thin adherent layer of oxide (40) on the platinum-group metal enriched outer layer (38) of the metallic article (26).

5. A method of applying a thermal barrier coating to a metallic article as claimed in 4 wherein the metallic article (26) comprises a superalloy substrate, the superalloy substrate comprises a gamma phase and gamma prime phase, the platinum-group metal enriched outer layer (38) comprises a platinum-group metal enriched gamma phase and a platinum-group metal enriched gamma prime phase.

6. A method as claimed in claim 4 wherein step (b) comprises aluminising the platinum-group metal enriched outer layer on the metallic article to form a platinum-group metal aluminide layer on the metallic article (26) and creating the thin adherent layer of oxide (40) on the platinum-group metal aluminide layer of the metallic article (26).

7. A method of applying a thermal barrier coating to a metallic article as claimed in any of claims 4 to 6 wherein the platinum-group metal comprises platinum.

8. A method of applying a thermal barrier coating to a metallic article as claimed in any of claim 4 to 7 wherein the thin adherent layer of oxide (40) is created by heating the platinum-group metal enriched outer layer (38) in an oxygen containing atmosphere.

9. A method as claimed in claim 2 wherein step (b) comprises enriching the metallic article with aluminium to form an aluminium enriched outer layer on the metallic article and creating the thin adherent layer of oxide on the aluminium enriched outer layer of the metallic article.

10. A method of applying a thermal barrier coating to a metallic article as claimed in claim 1 to 9 wherein the ceramic coating (42) is applied by electron beam physical vapour deposition or plasma spray physical vapour deposition.

11. A method of applying a thermal barrier coating to a metallic article as claimed in any of claims 1 to 10 wherein the ceramic coating (42) comprises yttria stabilised zirconia, yttria and erbia stabilised zirconia, yttria and gadolinia stabilised zirconia or yttria, erbia and gadolinia stabilised zirconia.

12. A method of applying a thermal barrier coating to a metallic article as claimed in any of claims 1 to 11 wherein the metallic article (26) is a nickel based superalloy, a cobalt based superalloy, a nickel based superalloy consisting of less than 1 ppm weight of sulphur or a cobalt based superalloy consisting of less than 1 ppm weight of sulphur.

13. A method of applying a thermal barrier coating to a metallic article as claimed in any of claims 1 to 12 wherein the metallic article (26) is a turbine blade, a turbine vane, a turbine shroud, a combustion chamber tile or a combustion chamber wall.

14. A method as claimed in any of claims 1 to 13 wherein step (a) produces a compressive residual stress of up to about 800MPa at the surface of the metallic article (26).

15. A method as claimed in any of claims 1 to 14 wherein step (a) produces a compressive residual stress of at least 500MPa at depths less than $10\mu$m from the surface of the metallic article (26).

16. A method as claimed in any of claims 1 to 15 wherein step (a) comprises providing part spherical shaped pockets (35) in at least one region of the surface of the metallic article (26) and providing grooves (35) in at least one region of the surface of the metallic article (26).

17. A method as claimed in any of claims 1 to 15 wherein step (a) comprises providing part spherical shaped pockets (35) in at least one region of the surface of the metallic article (26) and providing elongated pockets (35) in at least one region of the surface of the metallic article (26).

18. A method as claimed in any of claims 1 to 15 wherein step (a) comprise providing elongated pockets (35) in at least one region of the surface of the metallic article (26) with the pockets (35) elongated in a first direction and providing elongated pockets (35) in at least one region of the surface of the metallic article (26) with the pockets (35) elongated in a second direction different to the first direction.

19. A thermal barrier coated metallic article manufactured using a method as claimed in any of claims 1 to 18.

FIG. 1

EP 3 150 741 A1

FIG. 2

FIG. 3

FIG. 4

FIG. 8

FIG. 9

FIG. 5

**FIG. 10**

**FIG. 6**

**FIG. 7**

FIG. 11

FIG. 12

D    Cutter diameter
Rth   Theoretical height of ridges
ae   Step-over

FIG. 13

FIG. 4A

FIG. 4B

FIG. 14

FIG. 15

FIG. 17

FIG. 16

Europäisches
Patentamt

European
Patent Office

Office européen
des brevets

# EUROPEAN SEARCH REPORT

**Application Number**

EP 16 18 9124

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | WO 2004/043691 A1 (UNIV VIRGINIA [US]; WORTMAN DAVID J [US]; WADLEY HAYDN N G [US]) 27 May 2004 (2004-05-27)<br>* page 19, line 9- - line 22; figure 3 *<br>* page 18, line 23 *<br>* page 19, line 3 - line 8 *<br>* claim 4 *<br>* claim 1 *<br>* claim 69 *<br>* page 18, line 11 *<br>----- | 1-19 | INV.<br>C23C14/30<br>C23C14/08<br>C23C14/02<br>F01D5/28 |
| Y | US 2008/279678 A1 (MERRILL GARY B [US] ET AL) 13 November 2008 (2008-11-13)<br>* paragraph [0022]; figure 6 *<br>* page 19, line 9 - line 12 *<br>----- | 1-3, 10-19 | |
| Y | EP 0 902 104 A2 (ROLLS ROYCE PLC [GB]) 17 March 1999 (1999-03-17)<br>* paragraph [0056] *<br>* paragraph [0049] *<br>----- | 4,6,7,9 | |
| Y | US 2006/093851 A1 (DAROLIA RAMGOPAL [US] ET AL) 4 May 2006 (2006-05-04)<br>* paragraph [0004] *<br>----- | 5 | **TECHNICAL FIELDS SEARCHED (IPC)**<br><br>C23C<br>F01D |
| Y | US 6 210 812 B1 (HASZ WAYNE CHARLES [US] ET AL) 3 April 2001 (2001-04-03)<br>* column 7, line 41 - line 47 *<br>----- | 7,8 | |
| Y | US 2015/240651 A1 (THAM KOK-MUN [US] ET AL) 27 August 2015 (2015-08-27)<br>* paragraph [0107]; figure 12 *<br>----- | 18 | |

The present search report has been drawn up for all claims

| Place of search | Date of completion of the search | Examiner |
|---|---|---|
| The Hague | 21 February 2017 | Kudelka, Stephan |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 16 18 9124

This annex lists the patent family members relating to the patent documents cited in  the above-mentioned European search report.
The members are as contained in the European Patent Office EDP file on
The European Patent Office is in no way liable for these particulars which are merely given for the purpose of information.

21-02-2017

| Patent document cited in search report | | Publication date | Patent family member(s) | | Publication date |
|---|---|---|---|---|---|
| WO 2004043691 | A1 | 27-05-2004 | AU  2003287691 A1<br>US  2005266163 A1<br>WO  2004043691 A1 | | 03-06-2004<br>01-12-2005<br>27-05-2004 |
| US 2008279678 | A1 | 13-11-2008 | NONE | | |
| EP 0902104 | A2 | 17-03-1999 | DE  69824506 D1<br>DE  69824506 T2<br>EP  0902104 A2<br>US  6110604 A | | 22-07-2004<br>14-10-2004<br>17-03-1999<br>29-08-2000 |
| US 2006093851 | A1 | 04-05-2006 | DE 602005002334 T2<br>EP  1652964 A1<br>US  2006093851 A1 | | 29-05-2008<br>03-05-2006<br>04-05-2006 |
| US 6210812 | B1 | 03-04-2001 | US  6210812 B1<br>US  2002004143 A1 | | 03-04-2001<br>10-01-2002 |
| US 2015240651 | A1 | 27-08-2015 | CN  106030044 A<br>EP  3111050 A1<br>US  2015240651 A1<br>US  2016369637 A1<br>WO  2015130520 A1 | | 12-10-2016<br>04-01-2017<br>27-08-2015<br>22-12-2016<br>03-09-2015 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **WEERTMAN ; JOHANNES.** Theory of high temperature intercrystalline fracture under static or fatigue loads, with or without irradiation damage. *Metallurgical Transactions,* August 1974, vol. 5 (8), 1743-1751